# EUROPÄISCHE PATENTSCHRIFT

(11) **EP 2 089 146 B1**
(45) Veröffentlichungstag und Bekanntmachung des Hinweises auf die Patenterteilung: **18.08.2010**
(21) Anmeldenummer: 07819077.4
(22) Anmeldetag: 18.10.2007
(51) Int. Cl.: B01J 3/00, B01J 3/03, C23C 14/56

(54) **BANDSCHLEUSE**
BELT DISCHARGER
SAS À FEUILLARD

(30) Priorität: 27.10.2006 DE 102006051397; 01.03.2007 DE 102007009992
(43) Veröffentlichungstag der Anmeldung: 19.08.2009
(73) Patentinhaber: SMS Siemag AG, 40237 Düsseldorf (DE)
(72) Erfinder: GRAMER, Andreas, 42655 Solingen (DE); BEHRENS, Holger, 40699 Erkrath (DE); KRETSCHMER, Matthias, 50939 Köln (DE); SOHL, Ralf-Hartmut, 42699 Solingen (DE); DE KOCK, Peter, 46117 Oberhausen (DE); KÜMMEL, Lutz, 41363 Jüchen (DE)
(74) Vertreter: Klüppel, Walter
(86) Internationale Anmeldenummer: PCT/EP2007/009009
(87) Internationale Veröffentlichungsnummer: WO 2008/049543

(56) Entgegenhaltungen:
- DE-A1- 4 418 383
- DE-A1- 19 960 751
- DE-C1- 4 240 490

## Beschreibung

Die Erfindung betrifft eine Bandschleuse zur Abdichtung eines ersten Raumes gegenüber einem zweiten Raum, wobei beide Räume von einem Band, insbesondere einem Metallband, passiert werden, wobei zur Abdichtung der Räume mindestens zwei Rollen vorgesehen sind, die sich beidseitig des Bandes dichtend an dieses anlegen.

Bei der Herstellung und Veredelung eines Metallbandes, insbesondere eines Stahlbandes, ist es gelegentlich erforderlich, Prozesse in druckreduzierter Umgebung vorzunehmen (Vakuumprozess). Hierzu wird das Band in einen Raum geführt, der ein gegenüber dem Umgebungsdruck abgesenktes Druckniveau aufweist. Um einen kontinuierlichen Prozess zu erreichen, sind hierfür Bandschleusen der genannten Art notwendig, die das Band zwischen den Räumen unterschiedlichen Druckniveaus abdichten. Die Schleusen dienen also primär zum Aufbau einer Druckdifferenz zwischen zwei Bandbehandlungsbereichen.

Gattungsgemäße Bandschleusen sind beispielsweise aus der DE 4418 383 C2 und aus der DE 199 60 751 A1 bekannt. Dort ist beschrieben, dass sich an einer Schleusenstufe zwei Abdichtrollen an das Band anlegen, um es abzudichten, und zwar eine erste Abdichtrolle auf der Oberseite und eine zweite Abdichtrolle auf der Unterseite des Bandes. Um die Dichtigkeit der Schleusenstufe zu verbessern, sind dabei die zylindrisch ausgebildeten Walzen an ihrem Umfang mit einem Mantel aus elastischem, flexiblem Material umhüllt. Der Mantel kann sich dichtend an die Bandoberfläche anlegen und so die Dichtigkeit der Schleuse erhöhen.

Derartige Bandschleusen kommen generell für Produkte mit einem Breiten- zu Dickenverhältnis von wesentlich größer als 1 zum Einsatz. Sie können auch eingesetzt werden, um Kammern gegeneinander abzudichten, in denen unterschiedliche-Medien zur Bandbehandlung eingesetzt werden.

Die genannten vorbekannten Lösungen arbeiten dabei nicht immer voll zufriedenstellend. Dies gilt insbesondere, wenn sich chargenbedingt die Breite des abzudichtenden Bandes ändert. Die Anpassung der Bandschleuse auf Bänder unterschiedlicher Breite ist aufwändig und zeitigt nicht immer ein gutes Dichtungsergebnis.

Der vorliegenden Erfindung liegt daher die Aufgabe zugrunde, eine Bandschleuse der eingangs genannten Art so weiterzubilden, dass diesbezüglich eine Verbesserung erreicht werden kann. Die Schleuse soll also eine verbesserte Dichtwirkung aufweisen und universell für Bänder unterschiedlicher Breite und Dicke einsetzbar sein.

Die Lösung dieser Aufgabe durch die Erfindung ist **dadurch gekennzeichnet, dass** mindestens eine Rolle in einem ihrer axialen Endbereiche ein Dichtelement aufweist, das zur seitlichen Anlage an die Bandkante des Bandes ausgebildet ist, wobei Einstellmittel vorgesehen sind, mit denen die Rolle samt Dichtelement in axialer Richtung positioniert werden kann.

Mit dieser Ausgestaltung der Bandschleuse ist es möglich, die Rolle samt Dichtelement axial so zu positionieren, dass der Übergang von der Rolle zum Dichtelement genau in einem Bandkantenbereich zu liegen kommt. Das Dichtelement kann dann die Bandkante seitlich kontaktieren und so abdichten. Damit kann insbesondere im Bandkantenbereich, wo gemäß dem Stand der Technik sonst stets ein "Zwickel" unabgedichtet bleibt, ein besserer Dichteffekt erzielt werden.

Somit wird es möglich, die Abdichtfähigkeit der Bandschleuse im kritischen Bereich der Bandkanten wesentlich zu verbessern.

Bevorzugt sind beide Rollen in sich gegenüber liegenden axialen Endbereichen mit einem Dichtelement versehen.

Das Dichtelement ist dabei bevorzugt eine Dichtrolle. In diesem Falle kann vorgesehen werden, dass die Dichtrolle zumindest teilweise aus flexiblem, elastischem Material besteht. Die im einen axialen Endbereich der Rolle angeordnete Dichtrolle kann in einer mittels eines Federelements vorgespannten Schwinge gelagert sein.

Eine alternative Ausgestaltung sieht vor, dass das Dichtelement eine Dichtplatte ist. In diesem Falle kann vorgesehen werden, dass die Dichtplatte zur Anlage an die Stirnseite der gegenüberliegenden Rolle ausgebildet ist.

Zur weiteren guten Abdichtung sieht eine Weiterbitdung vor, dass an der Rolle, vorzugsweise oberhalb oder unterhalb der Rolle, ein Abdichtelement angeordnet ist. Dieses Abdichtelement kann als Abdichtleiste ausgebildet sein. Es kann alternativ hierzu auch als Abdichtrolle ausgeführt werden.

Zur effizienten Rückraumabdichtung kann vorgesehen werden, dass die mindestens eine Rolle an mindestens einer Abdichtrolle anläuft, die auf derselben Bandseite angeordnet ist. Die Abdichtrolle kann dabei an einer weiteren Abdichtrolle anlaufen. Zumindest eine der Abdichtrollen kann dabei an einer Dichtfläche anlaufen. Dabei ist bevorzugt vorgesehen, dass die Dichtfläche konkav ausgebildet ist, insbesondere der Form der sie kontaktietienden Abdichtrolle angepasst ist.

Um höhere Druckdifferenzen aufzubauen, hat es sich bewährt, wenn mehrere Schleusenstufen in Bandlaufrichtung hintereinander angeordnet sind.

Die Bandschleuse wird bevorzugt eingesetzt, um zur Abdichtung eines ersten Raumes mit einem ersten Druckniveau gegenüber einem zweiten Raum mit einem zweiten, vom ersten Druckniveau abweichenden Druckniveau zu dienen. Sie kann aber auch bei Druckgleichheit der Räume eingesetzt werden, wenn in diesen unterschiedliche Medien gegeneinander abgedichtet werden müssen; in diesem Falle ist also vorgesehen, dass die Bandschleuse zur Abdichtung eines ersten Raumes mit einem ersten Prozessmedium gegenüber einem zweiten Raum mit einem zweiten, vom ersten Prozessmedium verschiedenen Prozessmedium eingesetzt wird.

In der Zeichnung sind Ausführungsbeispiele der Erfindung dargestellt. Es zeigen:
- Fig. 1: als Kernstück einer Rollenschleuse zwei zusammenwirkende Rollen mit axial endseitig angeordneten Dichtrollen zur Abdichtung eines Bandes in Förderrichtung des Bandes gesehen,
- Fig. 2: den oberen Teil der Anordnung gemäß Fig. 1 in axiale Richtung ge- sehen,
- Fig. 3: eine zu Fig. 1 alternative Ausgestaltung der Bandschleuse,
- Fig. 4: den oberen Teil der Anordnung gemäß Fig. 3 in axiale Richtung ge- sehen,
- Fig. 5: eine weitere zu Fig. 1 alternative Ausgestaltung der Bandschleuse,
- Fig. 6: das Ende des Wellenzapfens der Rolle gemäß Fig. 5 mit einer Dicht- rolle, die von einer Schwinge gehalten wird in Förderrichtung des Bandes gesehen,
- Fig. 7: die zu Fig. 6 korrespondierende Ansicht insbesondere der Schwinge in axiale Richtung gesehen,
- Fig. 8: eine weitere zu Fig. 1 alternative Ausgestaltung der Bandschleuse,
- Fig. 9: die Anordnung gemäß Fig. 8 in axiale Richtung gesehen,
- Fig. 10: die Anordnung gemäß Fig. 8 in der Draufsicht,
- Fig. 11: eine zu Fig. 8 alternative Ausgestaltung der Bandschleuse (nur hälf- tig dargestellt) in Förderrichtung des Bandes gesehen,
- Fig. 12: die Anordnung gemäß Fig. 11 in axiale Richtung gesehen,
- Fig. 13: die Anordnung gemäß Fig. 11 in der Draufsicht,
- Fig. 14: eine weitere zu Fig. 8 alternative Ausgestaltung der Bandschleuse in Förderrichtung des Bandes gesehen,
- Fig. 15: die Anordnung gemäß Fig. 14 in der Draufsicht,
- Fig. 16: eine Rolle oberhalb des abzudichtenden Bandes mit einer hinter ihr angeordneten Abdichtrolle in axiale Richtung gesehen und
- Fig. 17: eine zu Fig. 16 alternative Ausführung der Rolle mit zwei hinter ihr angeordneten Abdichtrollen in axiale Richtung gesehen.

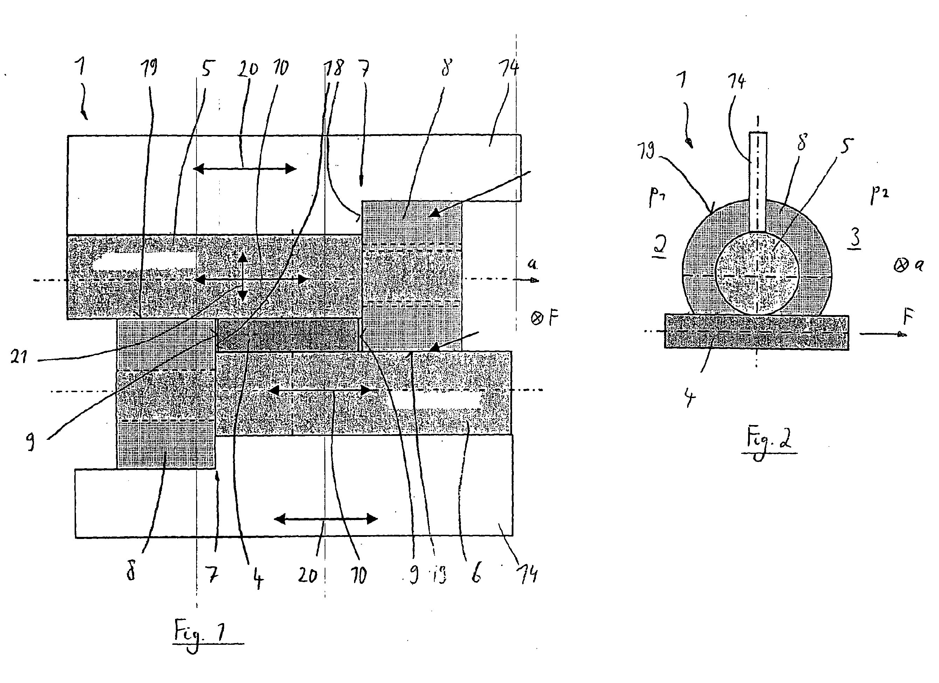

In den Figuren 1 und 2 st eine Bandschleuse 1 dargestellt, durch die ein Band 4 in Förderrichtung F kontinuierlich hindurchgeführt werden soll. Vor und hinter der Bandschleuse 1 wirken unterschiedliche Drücke p₁ und p₂ in Räumen 2 und 3. Um die Druckdifferenz zwischen den beiden Drücken auch im kontinuierlichen Betrieb aufrecht zu erhalten, dient die Bandschleuse 1. Zur Herstellung der Abdichtung weist die Bandschleuse 1 zwei Rollen 5 und 6 auf, die sich an die Bandoberseite bzw. an die Bandunterseite anlegen und in der Fläche des Bandes 4 für Dichtigkeit sorgen.

Um insbesondere in den seitlichen Bereichen des Bandes 4, also im Bereich der Bandkanten 9, Dichtigkeit herzustellen, ist die in den Figuren 1 und 2 dargestellte Ausgestaltung der Bandschleuse 1 vorgesehen.

Zur Abdichtung der flächigen Bereiche liegt - wie erwähnt - die Rolle 5 an der Oberseite des Bandes 4 und die Rolle 6 an der Unterseite des Bandes 4 an. Bei den Rollen 5, 6 kann es sich um Stahlrollen handeln. Möglich ist es auch, dass die Rollenoberfläche mit einem gut dichtenden Material beschichtet ist, z. B. mit einer gummiartigen Masse, die flexibel und elastisch ist.

In einem der axialen Endbereiche 7 der beiden Rollen 5, 6 ist ein Dichtelement 8 in Form einer Dichtrolle angeordnet. Die Dichtrolle 8 weist dabei eine zylindrische Form auf, so dass sie mit ihrer Stirnseite 18 die Bandkante 9 kontaktieren kann. Mit ihrem zylindrischen Bereich 19 läuft die Dichtrolle 8 an der gegenüberliegenden Rolle 6 bzw. 5 an. Die Dichtrolle 8 ist dabei in axiale Richtung a gesehen fest mit der Rolle 5 bzw. 6 verbunden. Bevorzugt weist die Dichtrolle zumindest einen Mantel auf, der aus flexiblem, elastischem Material besteht, z. B. aus Gummi.

Die Rolle 5, 6 ihrerseits steht mit einem nur sehr schematisch angedeuteten Bewegungselement 10 in Verbindung, das ein Einstellmittel darstellt, mit dem die axiale Lage der Rolle 5, 6 und damit auch der Dichtrolle 8 eingestellt werden kann.

Wie aus Fig. 1 ersichtlich ist, wird die Rolle 5, 6 samt Abdichtrolle 8 so mit den Einstellmittein 10 axial positioniert, dass der axiale Endbereich 7 der Rolle 5, 6 genau im axialen Bereich der Bandkante 9 liegt. Das hat zur Folge, dass bei entsprechender Wahl des Durchmessers der Dichtrolle 8 ein im Querschnitt rechteckförmiges Band 4 exakt von den beiden Rollen 5 und 6 sowie von den beiden seitlich angeordneten Dichtrollen 8 so umfasst bzw. eingefasst werden kann, dass eine zuverlässige Abdichtung des Bandes 4 gegeben ist.

Die weitere Abdichtung des Systems bestehend aus den Rollen 5 und 6 und der Dichtrollen 8 nach oben und nach unten wird durch Abdichtelemente 14 bewerkstelligt, die - entsprechend der in Fig. 1 ersichtlichen Kontur - geformt sind und sich an die Rolle 5, 6 und an die Dichtrolle 8 anlegen, so dass insoweit Dichtigkeit bezüglich einer nicht dargestellten Kammertrennwand gegeben ist. Wie es durch die in Fig. 1 eingetragenen Doppelpfeile 20 im Bereich der Abdichtelemente 14 angedeutet ist, werden die Abdeckelemente 14 bei der axialen Positionierung der Rollen 5, 6 und Dichtrollen 8 entsprechend mit verfahren.

Mit den genannten Einstellbewegungen können Bänder mit verschiedener Breite und Dicke problemlos abgedichtet werden, wobei die Einstellung auf eine neue Bandgeometrie schnell erfolgen kann. Die Einstellung auf unterschiedliche Banddicken erfolgt durch Bewegung der oberen Rolle 5 in Richtung des Doppelpfeils 21. Ist die Dichtrolle 8 aus elastischem Material gefertigt bzw. hat sie zumindest einen Mantel aus solchem Material, ist infolge der Flexibilität der Dichtrolle 8 dann ein gewisses Spektrum an Banddicken abdichtbar.

Die Einstellmittel 10 können als hydraulisch oder mechanisch arbeitende Elemente (z. B. Spindelhubelemente) ausgeführt sein.

Die Dichtrolle 8 kann frei drehend auf dem Wellenzapfen der Rolle 5, 6 gelagert werden. Hierdurch wird der Verschleiß minimiert, indem ein Ausgleich der Relativbewegungen möglich ist.

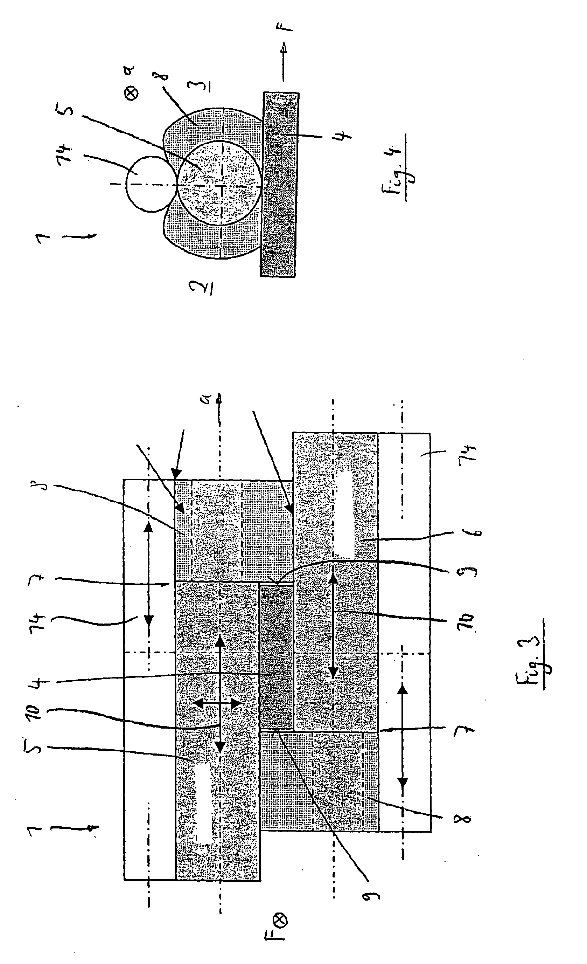

Die Lösung gemäß der Figuren 3 und 4 unterscheidet sich von derjenigen gemäß der Figuren 1 und 2 dadurch dass hier als Abdichtelement 14 eine Rolle eingesetzt wird. Diese hat über die gesamte Breite der in Fig. 3 dargestellten Schleusenstufe eine zylindrische Form mit konstantem Durchmesser. Demgemäß muss sie sich - wie es in Fig. 4 zu sehen ist - in das elastische Material der Dichtrolle 8 eindrücken, wodurch ein guter Dichteffekt zwischen Dichtrolle 8 und Abdichtelement 14 erreicht wird.

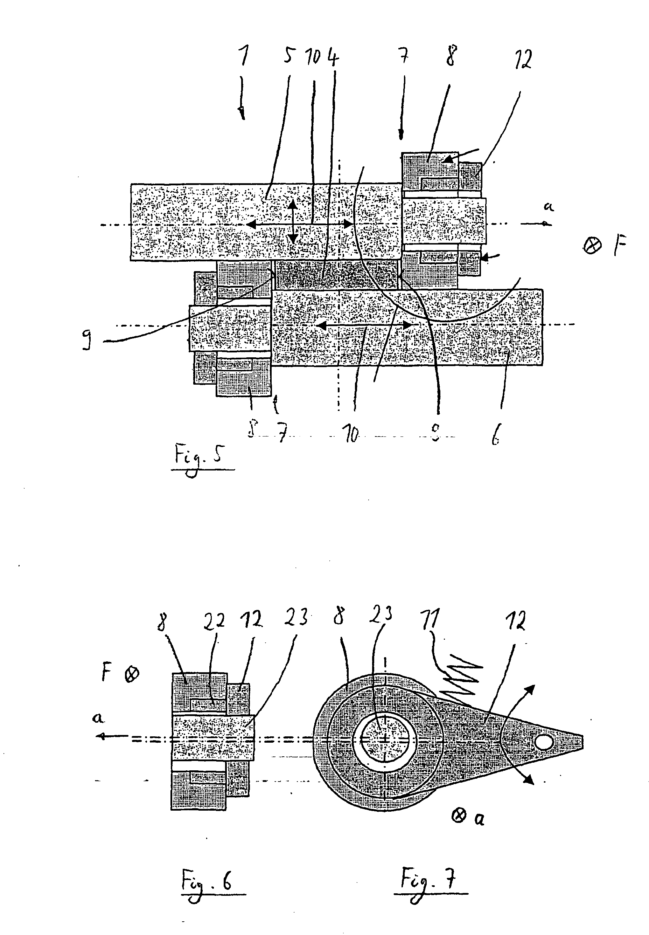

In den Figuren 5 bis 7 ist eine alternative Lösung zu sehen, bei der die Dichtrolle 8 in einer federvorgespannten Schwinge gelagert ist. Die Schwinge 12 ist im seitlichen Endbereich von Rolle 5, 6 und Dichtrolle 8 angeordnet (s. insbesondere Fig. 6) und haltert über eine Hülse 22 die Dichtrolle 8. Die Schwinge 12 ist, wie es in Fig. 7 gesehen werden kann, durch ein Federelement 11 vorgespannt, so dass die Dichtrolle 8 - mit geringfügigem radialen Freiheitsgrad gegenüber der Rolle 5, 6 - an die Bandoberfläche gedrückt werden kann (s. dargestellte Exzentrizität zwischen dem Wellenzapfen 23 der Rolle 5, 6 und der Dichtrolle 8 in den Figuren 6 und 7). Die Bewegungsmöglichkeit der Schwinge 12 und damit auch der Dichtrolle 8 ist durch den Doppelpfeil in Fig. 7 angedeutet.

Die Abdichtung im Bandkantenbereich erfolgt hier also über einen schwingengelagerten, drehbaren Bund. Der Bund hat im Verstellbereich der Rolle 5, 6 stets Kontakt zur Gegenrolle. Die Nachstellung kann aktiv oder auch passiv (z. B. über ein Federelement) erfolgen.

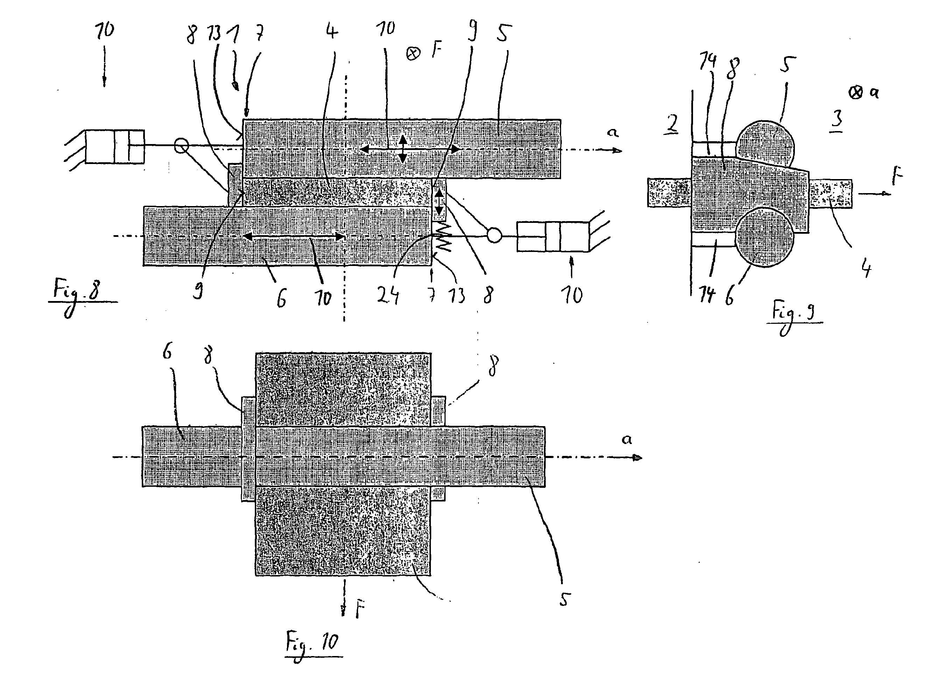

In den Figuren 8 bis 10 ist eine weitere alternative Ausgestaltung der Erfindung zu sehen. Hier kommen seitlich verschiebbare Dichtplatten 8 als Dichtelemente zum Einsatz.

Die Dichtplatten 8 sind dabei so ausgeführt, dass sie nicht nur die Bandkante 9 kontaktieren, sondern auch die Stirnseite 13 der gegenüberliegenden Rolle 5, 6. Neben der Bezeichnung des Doppelpfeils mit der Bezugsziffer 10 sind in Fig. 8 die Einstellmittel auch als Kolben-Zylinder-Systeme angedeutet. Die Abdichtelemente 14 sind-hier - wie aus Fig. 9 erkennbar - im rückwärtigen Bereich der Rollen 5, 6 angeordnet.

Die Abdichtung der Bandkante 9 erfolgt hier also über die Dichtplatten 8. Es ergibt sich eine Formkongruenz zwischen der Form der Bandkante 9 und derjenigen der Dichtplatte 8. Die Dichtplatten werden bei einer axialen Verschiebung der Rollen 5, 6 entsprechend (synchron) mit verschoben.

Bei Banddickenänderungen kann das den anstellbaren Rollen gegenüberliegende Dichtelement dabei aktiv oder passiv (mit einem Federelement 24) mit verschoben werden. Der Kontakt mit der Gegenrolle muss am Umfang der Rolle erhalten bleiben.

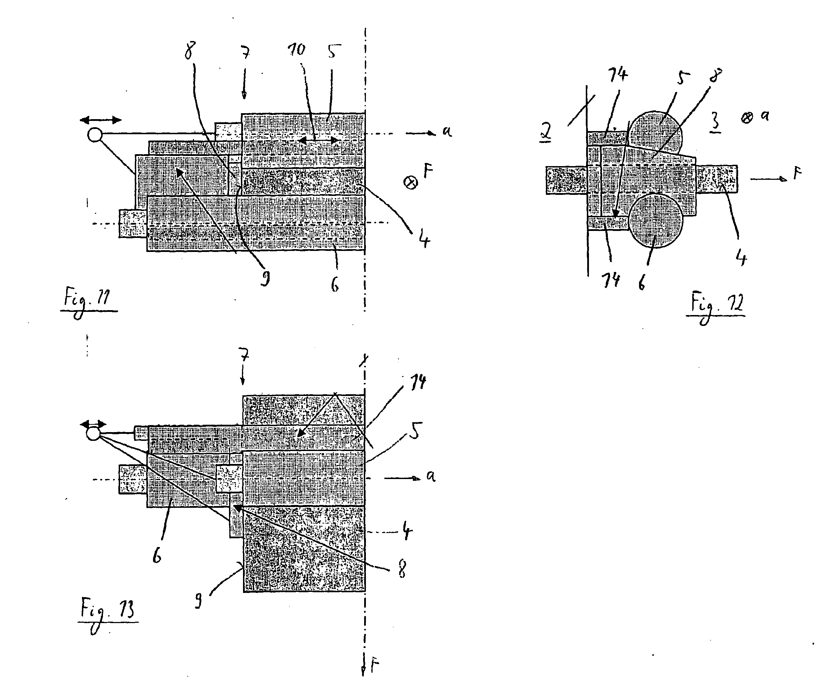

In den Figuren 11 bis 13 ist eine weitere alternative Ausgestaltung der Bandschleuse zu sehen, wobei sich diese Lösung an diejenige gemäß der Figuren 8 bis 10 anlehnt. Das als Dichtplatte 8 ausgebildete Dichtelement kann auch mehrteilig ausgeführt sein.

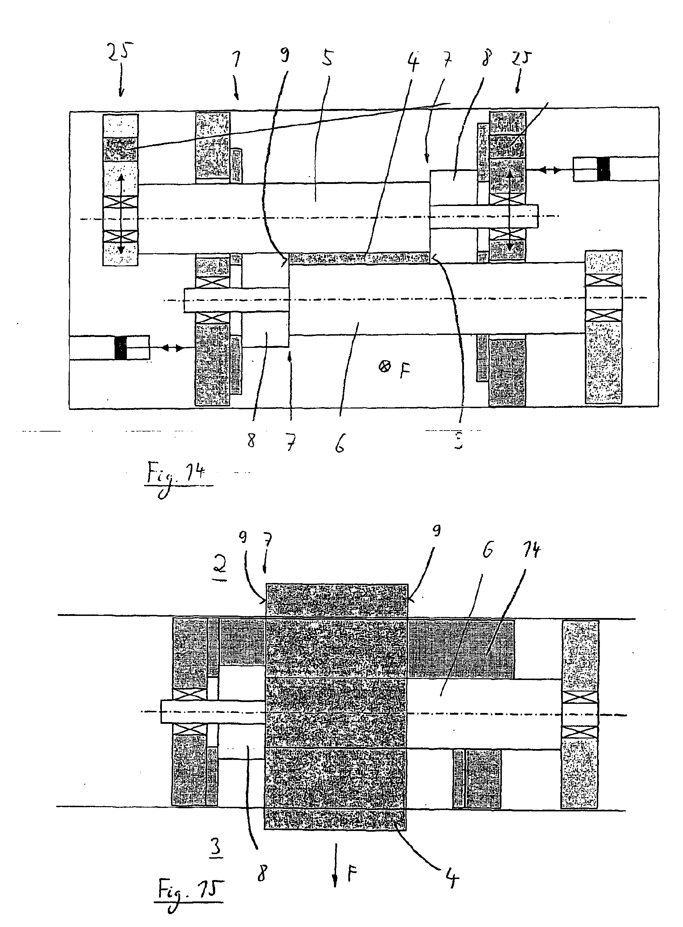

Bei der Ausgestaltung gemäß der Figuren 14 und 15 ist ein Anstellsystem 25 zur Einstellung der Anlage auf die Dicke des Bandes 4 illustriert. Hier kommen wieder Dichtrollen 8 als Dichtelemente zum Einsatz.

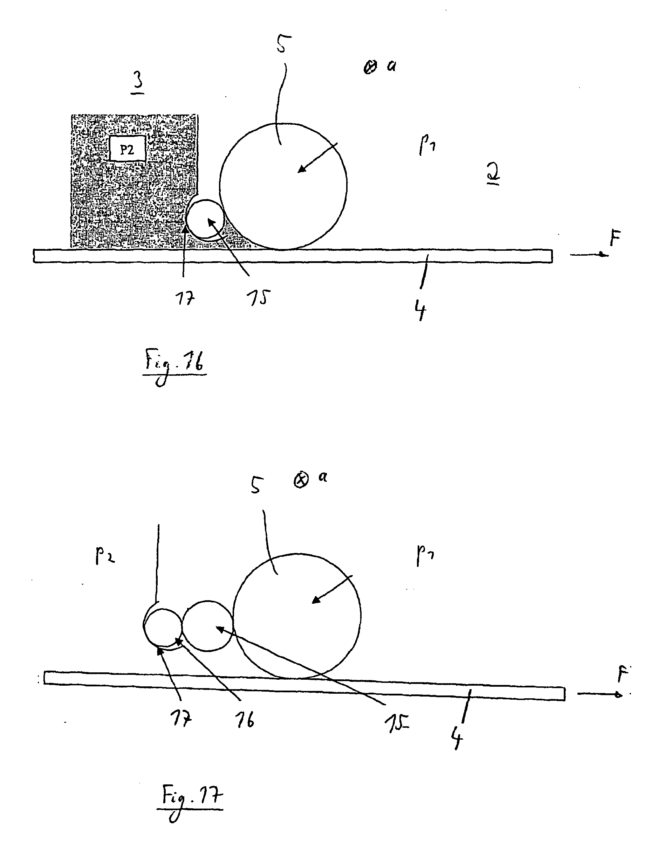

In Fig. 16 ist zu sehen, wie eine Rückraumabdichtung der Bandschleuse 1 bewerkstelligt werden kann. Die Rolle 5 liegt hier an einer Abdichtrolle 15 an, die sich gleich lang in Achsrichtung a erstreckt wie die Rolle 5. Die Abdichtrolle 15 wiederum läuft an einer Dichtfläche 17 an, die - der Form der Abdichtrolle 15 entsprechend - eine konkave Anlauffläche aufweist. Diese Anlauffläche stellt eine Gleitfläche bzw. ein Gleitlager dar.

An die den Prozessraum abdichtende Rolle 5 wird also eine feste Abdichtrolle 15 gedrückt. Diese bildet in Kombination mit der stützenden Gleitfläche 17 die Abdichtung im Rückraumbereich.

In Fig. 17 ist schließlich zu sehen, dass dieses Prinzip auch entsprechend genutzt werden kann, wenn zwei Abdichtrollen 15 und 16 eingesetzt werden. Die Abdichtrolle 15 kann hier als flexible Abdichtrolle ausgeführt sein. Diese wird von einer festen Abdichtrolle 16 auf der Rückseite abgedichtet. Die Abdichtrolle 16 bildet in Kombination mit der stützenden Gleitfläche 17 die Abdichtung im Rückraumbereich.

Mit der vorgeschlagenen Lösung können Räume unterschiedlichen Ducks, aber auch Räume gleichen Drucks gegeneinander abgedichtet werden, in denen sich verschiedenen Prozessmedien, insbesondere Prozessgase, aber auch Flüssigkeiten, befinden. Sofern seitliche Rollen vorgesehen werden, die an der Bandkante anlaufen, kann mit diesen eine gute seitliche Führung des Bandes erreicht werden. Auf der Bandoberfläche laufende Rollen können zur Führung von Blendenelementen genutzt werden.

### Bezugszeichenliste:

- 1: Bandschleuse
- 2: erster Raum
- 3: zweiter Raum
- 4: Band
- 5: Rolle
- 6: Rolle
- 7: axialer Endbereich
- 8: Dichtelement (Dichtrolle; Dichtplatte)
- 9: Bandkante
- 10: Einstellmittel
- 11: Federelement
- 12: Schwinge
- 13: Stirnseite
- 14: Abdichtelement
- 15: Abdichtrolle
- 16: Abdichtrolle
- 17: Dichtfläche
- 18: Stirnseite
- 19: zylindrischer Bereich
- 20: Doppelpfeil
- 21: Doppelpfeil
- 22: Hülse
- 23: Wellenzapfen
- 24: Federelement
- 25: Anstellsystem

- a: axiale Richtung
- F: Förderrichtung
- p₁: erster Druck
- p₂: zweiter Druck

## Patentansprüche

1. Bandschleuse (1) zur Abdichtung eines ersten Raumes (2) gegenüber einem zweiten Raum (3), wobei beide Räume (2, 3) von einem Band (4), insbesondere einem Metallband, passiert werden, wobei zur Abdichtung der Räume (2, 3) mindestens zwei Rollen (5, 6) vorgesehen sind, die sich beidseitig des Bandes (4) dichtend an dieses anlegen,
**dadurch gekennzeichnet,**
**dass** mindestens eine Rolle (5, 6) in einem ihrer axialen Endbereiche (7) ein Dichtelement (8) aufweist, das zur seitlichen Anlage an die Bandkante (9) des Bandes (4) ausgebildet ist, wobei Einstellmittel (10) vorgesehen sind, mit denen die Rolle (5, 6) samt Dichtelement (8) in axialer Richtung (a) positioniert werden kann.

2. Bandschleuse nach Anspruch 1,
**dadurch gekennzeichnet,**
**dass** beide Rollen (5, 6) in sich gegenüber liegenden axialen Endbereichen (7) mit einem Dichtelement (8) versehen sind.

3. Bandschleuse nach Anspruch 1 oder 2,
**dadurch gekennzeichnet,**
**dass** das Dichtelement (8) eine Dichtrolle ist.

4. Bandschleuse nach Anspruch 3,
**dadurch gekennzeichnet,**
**dass** die Dichtrolle (8) zumindest teilweise aus flexiblem, elastischem Material besteht.

5. Bandschleuse nach einem der Ansprüche 3 oder 4,
**dadurch gekennzeichnet,**
**dass** die im einen axialen Endbereich (7) der Rolle (5, 6) angeordnete Dichtrolle (8) in einer mittels eines Federelements (11) vorgespannten Schwinge (12) gelagert ist.

6. Bandschleuse nach Anspruch 1 oder 2,
**dadurch gekennzeichnet,**
**dass** das Dichtelement (8) eine Dichtplatte ist.

7. Bandschleuse nach Anspruch 6,
**dadurch gekennzeichnet,**
**dass** die Dichtplatte (8) zur Anlage an die Stirnseite (13) der gegenüberliegenden Rolle (5, 6) ausgebildet ist.

8. Bandschleuse nach einem der Ansprüche 1 bis 7,
**dadurch gekennzeichnet,**
**dass** an der Rolle (5, 6), vorzugsweise oberhalb oder unterhalb der Rolle (5, 6), ein Abdichtelement (14) angeordnet ist.

9. Bandschleuse nach Anspruch 8,
**dadurch gekennzeichnet, dass**
das Abdichtelement (14) eine Abdichtleiste ist.

10. Bandschleuse nach Anspruch 8,
**dadurch gekennzeichnet,**
**dass** das Abdichtelement (14) eine Abdichtrolle ist.

11. Bandschleuse nach einem der Ansprüche 1 bis 10,
**dadurch gekennzeichnet,**
**dass** die mindestens eine Rolle (5, 6) an mindestens einer Abdichtrolle (15) anläuft, die auf derselben Bandseite angeordnet ist.

12. Bandschleuse nach Anspruch 11,
**dadurch gekennzeichnet,**
**dass** die Abdichtrolle (15) an einer weiteren Abdichtrolle (16) anläuft.

13. Bandschleuse nach Anspruch 11 oder 12,
**dadurch gekennzeichnet,**
**dass** zumindest eine der Abdichtrollen (15, 16) an einer Dichtfläche (17) anläuft.

14. Bandschleuse nach Anspruch 13,
**dadurch gekennzeichnet,**
**dass** die Dichtfläche (17) konkav ausgebildet ist, insbesondere der Form der sie kontaktierenden Abdichtrolle (15, 16) angepasst ist.

15. Bandschleuse nach einem der Ansprüche 1 bis 14,
**dadurch gekennzeichnet,**
**dass** mehrere Schleusenstufen in Bandlaufrichtung hintereinander angeordnet sind.

16. Bandschleuse nach einem der Ansprüche 1 bis 15,
**dadurch gekennzeichnet,**
**dass** sie zur Abdichtung eines ersten Raumes (2) mit einem ersten Druckniveau (p₁) gegenüber einem zweiten Raum (3) mit einem zweiten, vom ersten Druckniveau abweichenden Druckniveau (p₂) eingesetzt wird.

17. Bandschleuse nach einem der Ansprüche 1 bis 15,
**dadurch gekennzeichnet,**
**dass** sie zur Abdichtung eines ersten Raumes (2) mit einem ersten Prozessmedium gegenüber einem zweiten Raum (3) mit einem zweiten, vom ersten Prozessmedium verschiedenen Prozessmedium eingesetzt wird.

## Claims

1. Strip-sealing gate (1) for sealing a first space (2) relative to a second space (3), wherein a strip (4), particularly a metal strip, passes through the two spaces (2, 3), wherein provided for sealing the spaces (2, 3) are at least two rollers (5, 6) which on both sides of the strip (4) sealingly bear thereagainst, **characterised in that** at least one of the rollers (5, 6) has in one of its axial end regions (7) a sealing element (8) constructed for sealing contact with the strip edge (9) of the strip (4), wherein setting means (10) by which the roller (5, 6) inclusive of sealing element (8) can be positioned in axial direction (a) are provided.

2. Strip-sealing gate according to claim 1, **characterised in that** the two rollers (5, 6) are provided with a sealing element (8) in mutually opposite axial end regions (7).

3. Strip-sealing gate according to claim 1 or 2, **characterised in that** the sealing element (8) is a sealing roller.

4. Strip-sealing gate according to claim 3, **characterised in that** the sealing roller (8) consists at least partly of flexible, resilient material.

5. Strip-sealing gate according to one of claims 3 and 4, **characterised in that** the sealing roller (8) arranged in one axial end region (7) of the roller (5, 6) is mounted in a rocker (12) biased by means of a spring element (11).

6. Strip-sealing gate according to claim 1 or 2, **characterised in that** the sealing element (8) is a sealing plate.

7. Strip-sealing gate according to claim 6, **characterised in that** the sealing plate (8) is constructed for contact with the end face (13) of the opposite roller (5, 6).

8. Strip-sealing gate according to any one of claims 1 to 7, **characterised in that** a sealing element (14) is arranged at the roller (5, 6), preferably above or below the roller (5, 6).

9. Strip-sealing gate according to claim 8, **characterised in that** the sealing element (14) is a sealing strip.

10. Strip-sealing gate according to claim 8, **characterised in that** the sealing element (14) is a sealing roller.

11. Strip-sealing gate according to any one of claims 1 to 10, **characterised in that** the at least one roller (5, 6) runs against at least one sealing roller (15) arranged on the same strip side.

12. Strip-sealing gate according to claim 11, **characterised in that** the sealing roller (15) runs against a further sealing roller (16).

13. Strip-sealing gate according to claim 11 or 12, **characterised in that** at least one of the sealing rollers (15, 16) runs against a sealing surface (17).

14. Strip-sealing gate according to claim 13, **characterised in that** the sealing surface (17) is of concave construction, in particular is adapted to the shape of the sealing roller (15, 16) contacting it.

15. Strip-sealing gate according to any one of claims 1 to 14, **characterised in that** several gate stages are arranged in succession in strip running direction.

16. Strip-sealing gate according to any one of claims 1 to 15, **characterised in that** it is used for sealing a first space (2) with a first pressure level (p₁) relative to a second space (3) with a second pressure level (p₂) differing from the first pressure level.

17. Strip-sealing gate according to any one of claims 1 to 15, **characterised in that** it is used for sealing a first space (2) with a first process medium relative to a second space (3) with a second process medium different from the first process medium.

## Revendications

1. Joint (1) pour bande pour fermer un premier espace (2) par rapport à un deuxième espace (3), les deux espaces (2, 3) étant traversés par une bande (4), en particulier une bande métallique, où on a prévu, pour la fermeture des espaces (2, 3) au moins deux rouleaux (5, 6) qui se placent de manière étanche contre les deux faces de la bande (4) **caractérisé**
**en ce qu'**au moins un rouleau (5, 6) présente dans une de ses zones d'extrémité axiales (7) un élément d'étanchéité (8) qui est réalisé pour buter latéralement contre le bord (9) de la bande (4), des moyens de réglage (10) étant prévus, avec lesquels le rouleau (5, 6) avec l'élément d'étanchéité (8) peut être position dans le sens axial (a).

2. Joint pour bande selon la revendication 1, **caractérisé en ce que** les deux rouleaux (5, 6) sont pourvus, dans des zones d'extrémité axiales opposées (7), d'un élément d'étanchéité (8).

3. Joint pour bande selon la revendication 1 ou 2, **caractérisé en ce que** l'élément d'étanchéité (8) est un rouleau d'étanchéité.

4. Joint pour bande selon la revendication 3, **caractérisé en ce que** le rouleau d'étanchéité (8) est constitué au moins partiellement d'un matériau souple, élastique.

5. Joint pour bande selon l'une quelconque des revendications 3 ou 4, **caractérisé**
**en ce que** le rouleau d'étanchéité (8) disposé dans une zone d'extrémité axiale (7) du rouleau (5, 6) est logé dans une boucle (12) précontrainte au moyen d'un élément à ressort (11).

6. Joint pour bande selon la revendication 1 ou 2, **caractérisé en ce que** l'élément d'étanchéité (8) est une plaque d'étanchéité.

7. Joint pour bande selon la revendication 6, **caractérisé en ce que** la plaque d'étanchéité (8) est réalisée pour buter contre la face frontale (13) du rouleau (5, 6) opposé.

8. Joint pour bande selon l'une quelconque des revendications 1 à 7, **caractérisé**
**en ce qu'**un élément d'étanchéité (14) est disposé au niveau du rouleau (5, 6), de préférence au-dessus ou en dessous du rouleau (5, 6).

9. Joint pour bande selon la revendication 8, **caractérisé en ce que** l'élément d'étanchéité (14) est une barre d'étanchéité.

10. Joint pour bande selon la revendication 8, **caractérisé en ce que** l'élément d'étanchéité (14) est un rouleau d'étanchéité.

11. Joint pour bande selon l'une quelconque des revendications 1 à 10, **caractérisé**
**en ce que** ledit au moins un rouleau (5, 6) frotte au moins contre un rouleau d'étanchéité (15) qui est disposé sur la même face de la bande.

12. Joint pour bande selon la revendication 11, **caractérisé en ce que** le rouleau d'étanchéité (15) frotte contre un autre rouleau d'étanchéité (16).

13. Joint pour bande selon la revendication 11 ou 12, **caractérisé en ce qu'**au moins un des rouleaux d'étanchéité (15, 16) frotte contre une surface d'étanchéité (17).

14. Joint pour bande selon la revendication 13, **caractérisé en ce que** la surface d'étanchéité (17) présente une forme concave, en particulier adaptée à la forme du rouleau d'étanchéité (15, 16) avec lequel elle est en contact.

15. Joint pour bande selon l'une quelconque des revendications 1 à 14, **caractérisé**
**en ce que** plusieurs étages de joint sont disposés les uns derrière les autres dans le sens d'avancement de la bande.

16. Joint pour bande selon l'une quelconque des revendications 1 à 15, **caractérisé**
**en ce qu'**il est utilisé pour fermer un premier espace (2) présentant un premier niveau de pression (p₁) par rapport à un deuxième espace (3) présentant un deuxième niveau de pression (p₂) différent du premier niveau de pression.

17. Joint pour bande selon l'une quelconque des revendications 1 à 15, **caractérisé**
**en ce qu'**il est utilisé pour fermer un premier espace (2) présentant un premier agent de procédé par rapport à un deuxième espace (3) présentant un deuxième agent de procédé différent du premier agent de procédé.
